# EUROPEAN PATENT SPECIFICATION

(11) **EP 0 284 414 B1**
(45) Date of publication and mention of the grant of the patent: **15.06.1994**
(21) Application number: 88302671.8
(22) Date of filing: 25.03.1988
(51) Int. Cl.: G02B 13/14, G03B 41/00

(54) **Exposure apparatus**
Belichtungsvorrichtung
Appareil d'exposition

(30) Priority: 27.03.1987 JP 74617/87
(43) Date of publication of application: 28.09.1988
(73) Proprietor: MATSUSHITA ELECTRIC INDUSTRIAL CO., LTD., Kadoma-shi, Osaka-fu, 571 (JP)
(72) Inventor: Ogawa, Kazufumi, Hirakata Osaka 573 (JP); Endo, Masayuki, Izumi Osaka 594 (JP); Sasago, Masaru, Hirakata Osaka 573 (JP); Ishihara, Takeshi, Neyagawa Osaka 572 (JP)
(74) Representative: Crawford, Andrew Birkby

(56) References cited:
- GB-A- 2 155 648
- JOURNAL OF OPTICS, vol. 15, no. 4A, September 1984, pp 281-285, Paris, Fr; G. ROBLIN: "Problèmes posés par la conception d'un objectif photoréducteur fonctionnant en UV".
- PATENT ABSTRACTS OF JAPAN, vol. 9, no. 112 (C-281)(1835), 16 May 1985 & JP A 605028
- PATENT ABSTRACTS OF JAPAN, vol. 5, no. 56 (P-57)(728), 17 April 1981 & JP A 5611408
- OPTIK, vol. 30, no. 4, 1970, pp 354-358, Stuttgart, DE; E. GLATZEL et al.: "UV-Sonnar 4/100, Bildwinkel = 41 Grad, aus Qarzglas und Flussspat. Korrektionsgang und Korrektionszustand".
- PATENT ABSTRACTS OF JAPAN, vol. 6, no. 158 (P-110), 16 April 1982 & JP A 57601

## Description

This invention relates to an exposure apparatus employing a projection lens, and more particularly, to a photolithographic exposure apparatus for manufacturing semiconductor devices.

Reduction projection type exposure apparatus (so-called steppers) using high pressure mercury lamps as a light source have been already marketed for use in high resolution processing of semiconductor devices, especially LSIs, VLSIs, etc. The resolution of conventional steppers, however, is limited to 0.8 »m for g-line and 0.6 »m for i-line since conventional steppers use the g-line (436 nm) and the i-line (365 nm) of super high pressure mercury lamps. It is almost impossible to obtain a resolution of 0.5 »m necessary for manufacturing 4M and 16 M bit dynamic memories with such wavelengths.

Studies are now being made for developing an exposure apparatus using an excimer laser of XeCl (308 nm), KrF (249 nm), ArF (193 nm), etc. as a light source.

A projection lens of a reduction projection exposure apparatus employing an excimer laser has the following problems.

Selection of glass material used for the reduction projection lens is limited in transmission factor because the wavelength of an excimer laser beam is very short. For instance, glass materials which can be used for wavelengths of KrF (249 nm) and ArF (193 nm) laser beams may limited to only two, i.e., pure quartz (SiO₂) and pure fluorite (CaF₂).

In conventional g-line and i-line, chromatic aberration occurs since there is wavelength dispersion as wide as about 10 nm. Therefore, when a reduction projection lens of an exposure apparatus employing g-line or i-line is designed, various aberrations including chromatic aberration have been corrected with a unit of several fractions of the wavelength by combining a plurality of lenses of different refraction index materials and by utilizing slight differences between refraction index and dispersion in lens materials.

Although the wavelength dispersion of a laser beam emitted from an excimer laser available today is smaller than that of g-line, i-line of the abovementioned super high pressure mercury lamp, there still exists dispersion at 0.1 nm or less and, the correction of chromatic aberration is required.

However, since for a deep UV ray such as an excimer laser beam, materials for lenses are limited as explained above, the only method which can be used is to combine a plurality of lenses of materials of the same refraction index and to change curvature radius of a spherical surface of each lens little by little, and therefore, it is extremely difficult to design a reduction projection lens, and also, the length of a reduction projection lens itself becomes very long (e.g., 1 m).

Further, CaF₂ has the drawback that it is softer than SiO₂ and therefore difficult to polish up. It is also difficult to acquire CaF₂ glass material with little deviation of refraction index. As a result, practically, CaF₂ can not be used as a lens material.

The article "Problèmes Posés par la Conception Dún Objectif Photoréducteur Fontionnant en UV" ("Problems in designing lenses for UV microlithography"), (Journal of Optics, vol. 15, no. 4A, Sept. 1984, pages 281-285) discusses the problems caused by the need for high resolution over a large field, this being problematic due to the effects of diffraction amongst other factors. The results of using various materials in the lenses of the microlithography apparatus are described. Some improvements in resolution over a large enough field for UV-microlithography are claimed.

This invention, therefore, provides an exposure apparatus which can realize super fine resolution photolithography process in manufacture of semiconductor devices, and employ a discontinuous (e.g. pulsative) energy beam, or more particularly, an excimer laser beam etc.

This invention relates to an exposure apparatus using single quartz lens which does not include materials other than quartz, in which exposure lenses are made of quartz with a refraction index controlled at a particular wavelength of a laser light by mixing impurities with quartz, but not using pure quartz, paying attention to a feature of laser light which is of single wavelength and does not have wavelength dispersion. This invention can make design of a lens easier, produce a high performance projection lens, and miniaturize a projection lens. This invention can also realize high performance exposure apparatus using a laser light for manufacturing semiconductor devices.

According to the present invention, there is an exposure apparatus comprising:
a UV-laser light source, an object stage and a lens system positioned in the optical path between the light source and the object stage, the lens system comprising:
a first lens of a first refraction index to deep UV laser light, said first lens being made of a first glass material of synthesized quartz mixed with an impurity; and;
a second lens of a second refraction index which is different from said first refraction index, said second lens being made of a second glass material of synthesized quartz without any impurity or of synthesized quartz mixed with the impurity by a ratio different from that in said first glass material.

The first lens may be made of glass materials made up of synthesized quartz produced by the CVD method using gas such as SiCl₄ and mixed with certain amounts of impurities. Synthesized quartz can be obtained to a high purity, unlike that made by melting natural quartz. The second lens is made of synthesized quartz without any impurity or with a different ratio of impurity different from that of the first lens. An object is irradiated with the laser light through the first and second lenses. The deep UV laser light is, for instance, a beam of a KrF or XeCl excimer laser light, and the impurity is, for instance, fluorine. The projection lenses of the exposure apparatus of this invention are made by combining two or more types of glass materials which is made of quartz with refraction index controlled at a particular wavelength or of the quartz mixed with fluorine. According to the present invention as described herein, the following benefits, among others, are obtained. (1) The level of freedom of lens design and the performance of chromatic aberration correction can be improved since a plurality of glass materials with controlled refraction index which are made of synthesized quartz, and of the synthesized quartz mixed with fluorine as an impurity in designing projection lenses for semiconductor manufacturing exposure apparatus, for example, lenses of KrF excimer laser light (248 nm), XeCl excimer laser light (308 nm), and ArF excimer laser light (193 nm). (2) Further, designing an exposure apparatus is made easier and an exposure apparatus can be made more compact by use of the invention which uses the above-stated lens. (3) High accuracy quartz-based projection lenses which can be used for deep UV laser beams can be manufactured by the present invention. (4) Since the invention greatly increases level of freedom in selection of glass materials upon designing lenses, lens design accuracy such as chromatic aberration correction is largely improved and time required for designing is considerably shortened. (5) Lenses in this invention can provide high resolution for a VLSI manufacturing exposure apparatus requiring a resolution of about 0.5 »m, especially, for an exposure apparatus using deep UV ray of KrF excimer laser etc. This contributes considerably to the improvement of semiconductor device manufacturing techniques.
(6) This invention also has an advantage of shortening the length of a lens from about 1 m in conventional one to 60 cm. Consequently, the invention is advantageous for making a reduction projection exposure apparatus compact.

Incidentally, the source of excimer laser is not limited to KrF. Further, it is clear that the same results can be obtained on a reflection type reduction projection exposure apparatus.

While the novel features of the invention are set forth in the appended claims, the invention, both as to organization and content, will be better understood and appreciated, along with other objects and features thereof, from the following detailed description taken in conjunction with the drawings.

### Brief Description of the Drawings

Fig. 1 shows schematically an excimer laser exposure apparatus of the present invention,
Fig. 2 shows a characteristic curve of the refraction index of synthesized quartz and synthesized quartz mixed with an impurity as glass material;
Fig. 3 shows an example of lens system that was actually manufactured;
Figs. 4A, 4B and 5 show examples of methods of manufacturing glass materials according to the invention.

### Detailed Description of the Invention

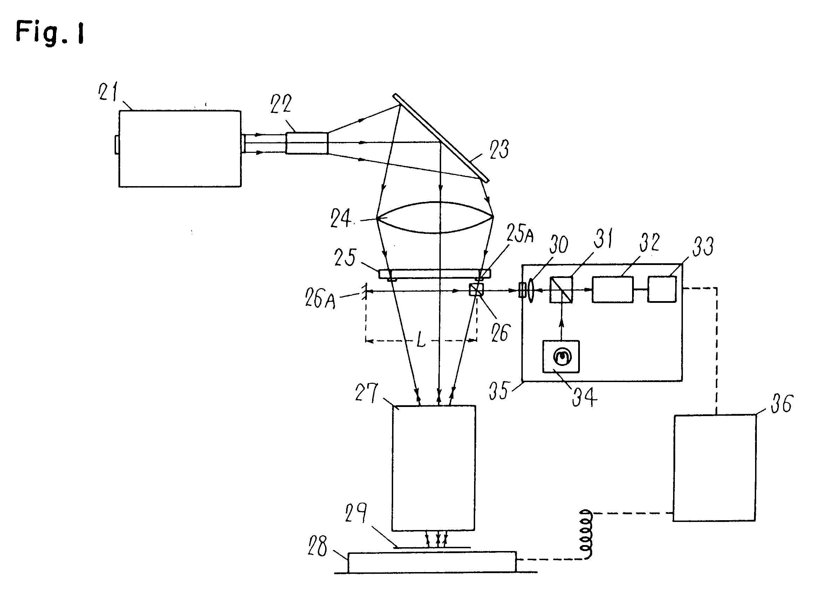

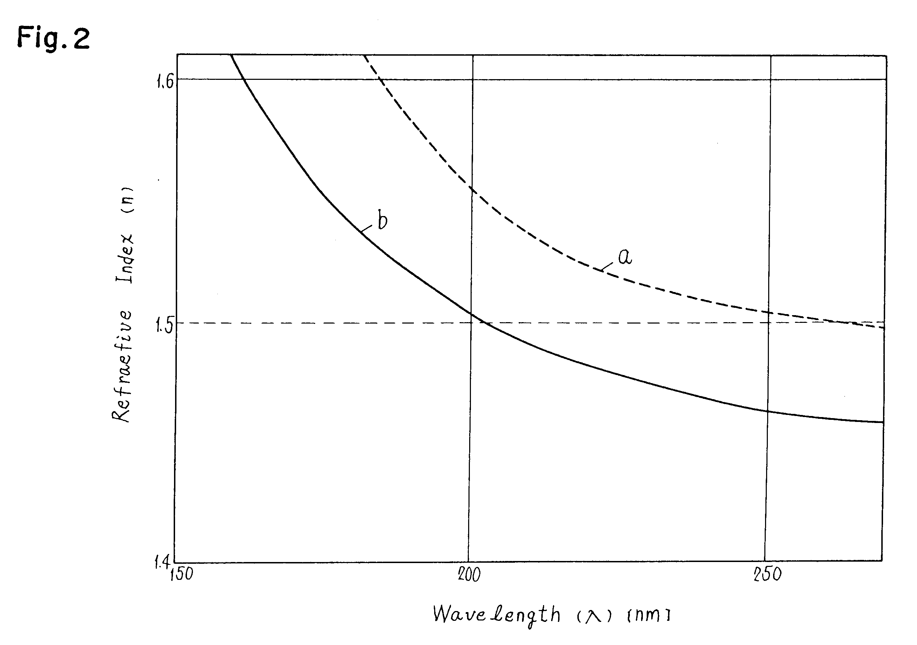

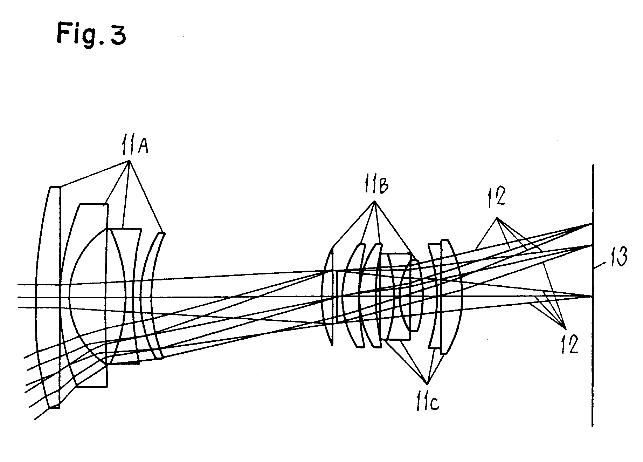

Fig. 1 shows an example of an exposure apparatus of the invention. Projection lenses used for the exposure apparatus are first explained with reference to Figs. 2 and 3 before describing the exposure apparatus.

The refraction index curve (a) in Fig. 2 shows dependence characteristic of refraction index of synthesized quartz without fluorine. If a light beam incident to the projection lenses is a KrF excimer laser beam, 248 nm, the refractive index is 1.508 as shown in Fig. 2. On the other hand, refraction index of glass material including 4.5% fluorine impurity (quartz mixed with an impurity) is represented by curve (b), and refraction index is 1.47 at a wavelength of 248 nm. This means that two glass materials of the same quartz base are available, i.e., one of refractive index of 1.508 and the other of 1.47 of a wavelength of 248 nm by regulating refraction index by mixing fluorine with quartz. In the same manner, a lens of desired refractive index can be produced by using glass materials with different refractive index by controlling the amount of impurity to be mixed.

The g-line, i-line of a super-high pressure mercury lamp has too great wavelength dispersion so that refraction index can not be controlled even if impurity is mixed with glass material of each lens.

Fig. 3 shows an example of a reduction lens unit for deep UV ray which comprises 12 lenses made of glass materials of three different refractive indexes according to this invention.

Lenses 11A, 11B and 11C are made of glass materials produced in the above manner. For example, the lenses 11B do not include fluorine, and lenses 11A and 11C include predetermined amounts of fluorine for acquiring any refraction indexes which is needed. 12 designates light beam or light flux and 13 designates a surface of a semiconductor wafer.

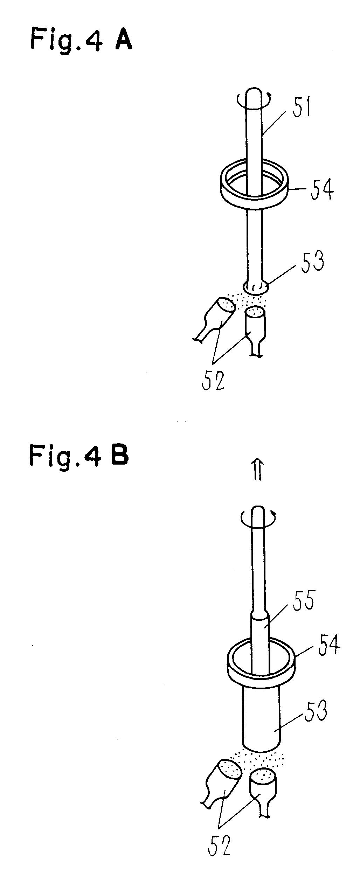

A method of preparing glass materials used for the above projection lenses is explained. A VAD (vapor axis deposition) method is first described. As shown in Figs. 4A, SiO₂, GeO₂, etc. are separated and produced at the tip of glass rod called start rod 51 by flame hydrosis using oxygen-hydrogen (O₂+H₂) burners 52. The rod 51 is pulled up with progress of separation and production of porous base material 53 and the separated porous material is fused by use of a carbon heater 54 located above (Fig. 4B) for making transparent base material (glass material) 55. At the time, SiCl₄ and GeCl₄, raw materials of SiO₂ and GeO₂, are carried with O₂+H₂ as carrier gas. At this time, fluorine can be added by supplying gas including fluorine simultaneously.

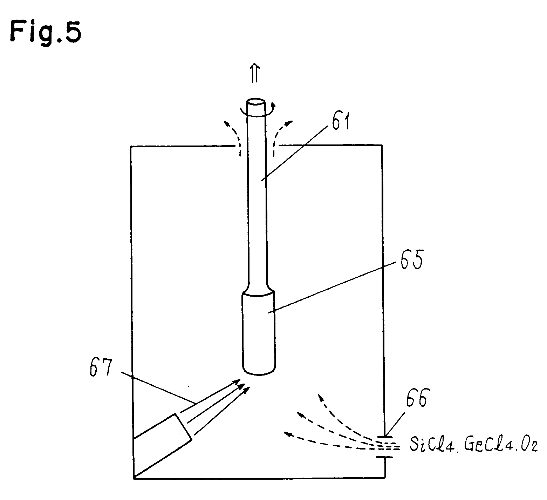

An improved method is described. As shown in Fig. 5, a start rod 61 made of, for instance, quartz is set in an enclosed vessel, and the tip of the start rod 61 is heated by focussing a carbon dioxide gas laser beam 67 thereon, while supplying a mixture gas of SiCl₄ and O₂ as an atmospheric gas from gas inlet 66. As a result, SiO₂ is produced only at the heated portion, and the start rod 61 is pulled up while spinning it with progress of separation and production. Whereby, transparent base material (glass material) 65 is made.

A chemical formula of this reaction is:

SiCl₄ + O₂→SiO₂ + Cl₂.

Since H₂ is not used, OH is not produced in principle and base material (glass material) of pure quartz glass is made.

Transparent base material can be made all at once by controlling laser output, start rod rotation speed, and atmospheric gas amount.

The reason why the carbon dioxide gas laser is used is that wavelength of laser beam is 10.6 »m which is absorbed by quartz glass at a high rate and only a tip of the separated/produced base material is heated effectively. This is highly effective for causing the reaction of SiCl₄+O₂ at the tip of the base material and fusing separated SiO₂ An impurity, fluorine gas, is added by supplying fluorine gas.

An example of an exposure apparatus using the above projection lenses is described with reference to Fig. 1. It comprises a light source 21, for instance, a KrF (248 nm) excimer laser, an integrator which shapes and homogenizes the light beam emitted from the laser light source 21, a large full reflection mirror 23 which converts the light path by 90°, a condenser lens 24 made of quartz for irradiating reticle 25 serving as a mask and a reduction lens unit 27, reticle 25, a main beam splitter 26 and an opposing mirror 26A for alignment, and a reducing projection lens 27 made of quartz.

The main optical system of the reduction projection exposure apparatus projects an image on a resist layer coated on a wafer 29 which is positioned at an imaging point on XYZ stage 28. An alignment optical system comprises an alignment lens 30, alignment beam splitter 31, image processing and wavelength conversion IIT 32, and image processing CCD camera arranged n the order on an optical axis almost perpendicular to the exposing light path. An alignment mark irradiation alignment light source (beam separated from, for instance, the beam of a super-high pressure mercury lamp, or a laser) is mounted on an XY drive system 35 for irradiating a desired portion of the wafer 29. The alignment optical system and the XYZ stage 28 on which the wafer 29 is mounted are controllerable by a control computer 36 for image processing and alignment signal processing.

The alignment optical system is now described in detail. An i-line (365 nm) or j-line (313 nm) separated from the alignment irradiation system 34 (for instance, an Xe-Hg super-high pressure lamp) by use of a cut filter (when a KrF excimer beam (248 nm) is used for the reduction projection lens unit 27 and the excimer laser light source 21) irradiates the main beam splitter 26 of the main optical system by the alignment beam splitter 31 through the alignment lens 30. At this time, irradiation is carried out arbitrarily by the alignment system XY drive system 35 according to the alignment mark position of the reticle and the wafer. The alignment irradiation light, 313 or 365 nm ultraviolet light, irradiates the alignment mark 25A of the reticle 25 through the main beam splitter 26, and at the same time the alignment mark on the wafer 29 through the main beam splitter 26 and the counter mirror 26A. The reflecting light returns to the alignment mark on the wafer 29 through the main beam splitter 26 and the counter mirror 26A, and at the same time, returns the image of the alignment mark 25A on the reticle 25 to the alignment lens 30 through the main beam splitter 26. On this occasion, the alignment focus deviates from the exposing focus because of chromic aberration occuring since the exposing wavelength is 248 nm and the alignment wavelength is for example, 313 nm, 365 nm. The aberration generally can not be corrected by reducing lenses like those used in the present invention. Here, by adjusting the distance L between opposing mirror 26A and beam splitter 26, the light path length of the alignment light can be changed, and it becomes possible to make the alignment key on the reticle and the alignment key on the wafer the same focus as light of exposing light wavelength.

Further, a very high resolution can be acquired since the images of the alignment marks on the wafer 29 and the reticle 25 are magnified by the reduction projection lens unit 27 and the alignment lens 30. The image (ultraviolet ray image) is processed by use of an image intensifier (IIT) 32 having a micro-channel plate (MC) for making the image visible (ultraviolet range image is not observable by human eyes or video processing) for amplifying the image signal to improve the S/N ratio. At this time, the image becomes observable in the visible range if the wavelength of the image is made 500 nm or more. Finally, pixel pattern recognition processing is carried out by the CCD camera 33. The higher the CCD camera resolution, the better, needless to say, but it is not a dominant factor since the image is magnified and converted to visible light.

The image intensifier (IIT) can be a V1506 (manufactured by Hamamatsu Photonics Co., Ltd., sensitivity range is 150 ∼ 320 nm) which has a Cs-Te photoelectric layer, and the micro-channel plate can be F1217 (manufactured by Hamamatsu Photonics Co., Ltd.).

Although the above-explained example employs KrF (248 nm) for the exposure and j-line (313 nm) or i-line (365 nm) for the alignment, d-line or e-line may be used for the alignment. When the d-line or e-line are used for the alignment light, the IIT is not necessary because they are visible light. However, the distance (L) between the opposing mirror and the main beam splitter should be increased extremely since chromic aberration is larger than that of the i-line or j-line.

## Claims

1. An exposure apparatus comprising:
a UV-laser light source, an object stage and a lens system positioned in the optical path between the light source and the object stage, the lens system comprising:
a first lens of a first refraction index to deep UV laser light, said first lens being made of a first glass material of synthesized quartz mixed with an impurity; and;
a second lens of a second refraction index which is different from said first refraction index, said second lens being made of a second glass material of synthesized quartz without any impurity or of synthesized quartz mixed with the impurity by a ratio different from that in said first glass material.

2. An exposure apparatus of claim 1, wherein said deep UV laser light source is a KrF or XeCl excimer laser.

3. An exposure apparatus according to claims 1 or 2, wherein said impurity is fluorine.

4. An exposure apparatus according to claims 1, 2 or 3 wherein said apparatus is a reduction projection type exposure apparatus, said apparatus including an excimer laser light source as said UV-laser light source and a reticule through which laser light from said light source passes; and wherein said lens system is a reduction projection lens for receiving laser light which has passed through said reticule; said apparatus further including a substrate on which laser light from said reduction projection lens is irradiated.

5. An exposure apparatus according to claim 4 wherein said substrate has a resist layer formed thereon.

## Patentansprüche

1. Eine Belichtungsvorrichtung umfassend:
eine UV-Laserlichtquelle, eine Gegenstandsbühne und ein Linsensystem, das in dem optischen Weg zwischen der Lichtquelle und der Gegenstandsbühne angeordnet ist, wobei das Linsensystem umfaßt:
eine erste Linse mit einem ersten Brechungsindex für tiefes UV-Laserlicht, wobei die genannte erste Linse aus einem ersten Glasmaterial aus synthetischem Quarz hergestellt ist, der mit einer Verunreinigung vermischt ist; und
eine zweite Linse mit einem zweiten Brechungsindex, der von dem genannten ersten Brechungsindex verschieden ist, wobei die genannte zweite Linse aus einem zweiten Glasmaterial aus synthetisiertem Quarz ohne irgendeine Verunreinigung oder aus synthetischem Quarz hergestellt ist, der mit der Verunreinigung mit einem Verhältnis vermischt ist, das von demjenigen des genannten ersten Glasmaterials verschieden ist.

2. Eine Belichtungsvorrichtung des Anspruchs 1, bei der die genannte tiefe UV-Laserlichtquelle ein KrF oder XeClₓ Excimer-Laser ist.

3. Eine Belichtungsvorrichtung gemäß Anspruch 1 oder 2, bei der die genannte Verunreinigung Fluor ist.

4. Eine Belichtungsvorrichtung gemäß Anspruch 1, 2 oder 3, bei der die genannte Vorrichtung eine Belichtungsvorrichtung vom Typ mit Verkleinerungsprojektion ist, die genannte Vorrichtung eine Excimer-Laser-Lichtquelle als die genannte UV-Laserlichtquelle und eine Strichplatte enthält, durch die Laserlicht von der genannten Lichtquelle hindurchgeht; und bei der das genannte Linsensystem eine Verkleinerungsprojektionslinse zum Empfangen von Laserlicht ist, das durch die genannte Strichplatte hindurchgegangen ist; wobei die genannte Vorrichtung ferner ein Substrat einschließt, das mit Laserlicht von der genannten Verkleinerungsprojektionslinse bestrahlt wird.

5. Eine Belichtungsvorrichtung gemäß Anspruch 4, bei der das genannte Substrat eine darauf gebildete Resistschicht aufweist.

## Revendications

1. Appareil d'exposition comprenant :
une source de lumière laser UV, un étage objet et un système d'objectif positionné dans le chemin optique entre la source de lumière et l'étage objet, le système d'objectif comprenant :
un premier objectif d'un premier indice de réfraction afin de rendre plus profonde la lumière laser UV, ledit premier objectif étant constitué par un premier matériau de verre en quartz de synthèse mélangé à une impureté ; et
un second objectif d'un second indice de réfraction qui est différent dudit premier indice de réfraction, ledit second objectif étant réalisé en un second matériau de verre en quartz de synthèse sans impureté ou en quartz de synthèse mélangé avec l'impureté selon un rapport différent de celui dans ledit premier matériau de verre.

2. Appareil d'exposition selon la revendication 1, dans lequel ladite source de lumière laser UV profonde est un laser excimer KrF ou XeCl.

3. Appareil d'exposition selon la revendication 1 ou 2, dans lequel ladite impureté est du fluor.

4. Appareil d'exposition selon la revendication 1, 2 ou 3, dans lequel ledit appareil est un appareil d'exposition du type projection en réduction, ledit appareil incluant une source de lumière laser excimer en tant que dite source de lumière laser UV et un réticule au travers duquel la lumière laser provenant de ladite source de lumière passe ; et dans lequel ledit système d'objectif est un objectif de projection en réduction pour recevoir de la lumière laser qui a traversé ledit réticule ; ledit appareil incluant en outre un substrat sur lequel de la lumière laser en provenance dudit objectif de projection en réduction est irradiée.

5. Appareil d'exposition selon la revendication 4, dans lequel ledit substrat comporte une couche de réserve formée sur lui.
